# EUROPEAN PATENT APPLICATION

(11) **EP 2 787 639 A1**
(43) Date of publication of application: **08.10.2014**
(21) Application number: 13162363.9
(22) Date of filing: 04.04.2013
(51) Int. Cl.: H03K 3/021, H03K 17/041, H03K 17/567

(54) **Cascode bipolar transistor circuit**

(71) Applicant: NXP B.V., 5656 AG Eindhoven (NL)
(72) Inventor: Blom, Anton, Redhill, Surrey RH1 1NY (GB); Koper, Nick, Redhill, Surrey RH1 1NY (GB)
(74) Representative: Hardingham, Christopher Mark

(57) **Abstract**

The invention provides a cascode switching circuit comprising a bipolar junction transistor and a control switch. A boost current supply circuit is coupled to the base of the bipolar junction transistor for supplying a boost current when the control switch is turned on. This reduces the collector-emitter saturation voltage from the moment of switching on.

## Description

This invention relates to cascode bipolar transistor circuits.

In many applications, switching of electrical current is preferably done by means of power MOSFETs. Power MOSFETs have favourable switching properties and driving power MOSFETs can be achieved without great effort.

Power MOSFETs show rather high losses during the on-state. The on-state losses can be reduced by using a larger chip area, but larger chip sizes result in an increased cost of the MOSFETs and generally in higher switching losses.

For mains voltage applications, or for applications where the applied electronic switch needs to have a relatively high voltage rating (typically 400V), a bipolar transistor can be a good alternative. The chip size is by default much smaller (and therefore more cost effective) than the chip size of the corresponding MOSFETs replacement.

However, a problem with the use of bipolar transistors is that to drive the base of the bipolar transistor, a rather high base current is required in order to achieve a sufficiently low collector-emitter voltage, which in turn is required to realize low on-state conduction power loss. This current has to be supplied by the driver supply, but these drive currents can be too high to be generated in an economical way for large volume applications.

In practice the high voltage bipolar transistor collector-emitter saturation voltage can be reduced by applying an additional initial current pulse that injects charge carriers into the bipolar switching device, and thus avoids unnecessary excessive on-state losses. This additional current pulse is advantageous for power applications, typically 10W and higher, and especially when smaller bipolar junction transistor types are to be used in the application for cost reasons.

In known solutions, the required base current including the starting pulse requires large components, resulting in increased component costs. In addition, the current transfer ratio of medium and high voltage transistors is rather limited. In many cases, the current transfer ratio is as low as 10 to 20, resulting in a base drive requirement up to 10% of the collector current. This means that the base driver circuit is highly inefficient due to the level of the required base current.

Thus, when designing the base driver stage for a bipolar high voltage bipolar transistor, generating the supply for the base driver circuit is an important aspect due to the high required current levels.

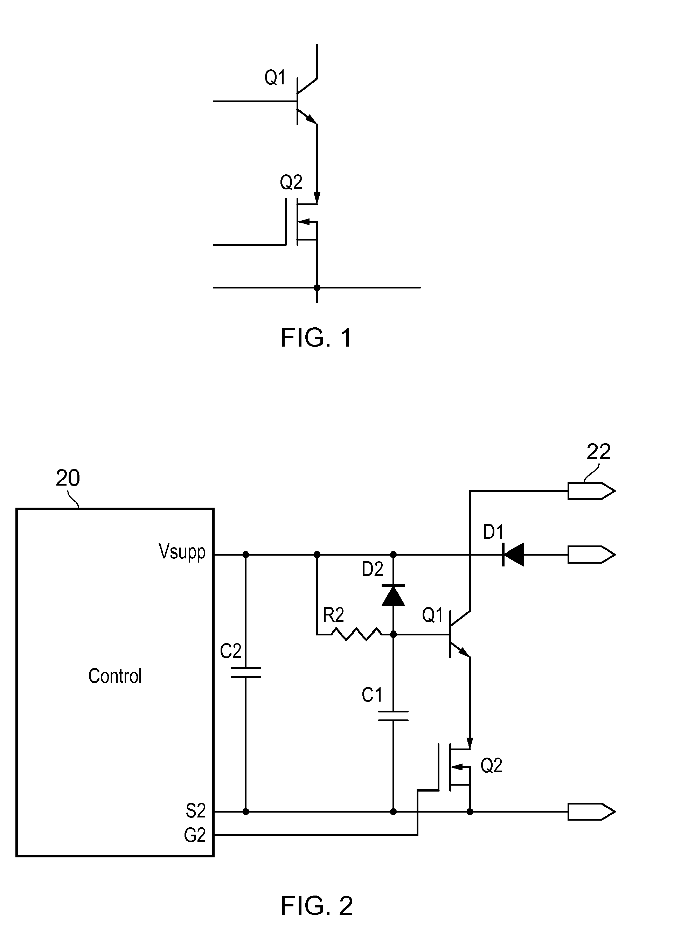

Figure 1 shows a known cascode circuit based on an emitter switching topology, which takes the form of a cascode circuit of two transistors in series. The cascode circuit uses a bipolar (NPN or PNP) output transistor Q1, with its emitter connected to a MOSFET Q2.

The switching characteristics of the circuit are improved and the switching losses are limited. In particular, at the moment the base-emitter junction is blocked and is unable to carry any current, the excess charge carriers in the bipolar high voltage NPN transistor will cause a current from the collector to the base, discharging the collector-base junction space-charge region. This current will flow until the collector-base space-charge region is depleted. In a flyback application or other topologies where an inductive load is switched, the value of the negative base current is dictated by the actual collector current at switching off.

As result the high negative base current guarantees a relatively fast and efficient way of switching off of the bipolar transistor.

Supplying the drive current for the high voltage NPN transistor can be challenging due to the high required base current levels.

The invention is defined by the claims.

According to the invention, there is provided a switching circuit, comprising:
a bipolar junction transistor;
a control switch in series with the bipolar junction transistor with a higher voltage supply across the series connection, wherein the base of the bipolar junction transistor is supplied with current by a lower voltage supply, and wherein the control switch is turned on to turn on the bipolar junction transistor; and
a boost current supply circuit coupled to the base of the bipolar junction transistor for supplying a boost current to the base of the bipolar transistor when the control switch is turned on, wherein the boost current supply circuit comprises a capacitor between the base of the bipolar junction transistor and a terminal of the lower voltage supply.

The invention provides a switching topology with enhanced switching efficiency. The invention provides a cascode circuit, by which is meant a main output transistor in series with a secondary transistor to which switch control signals are applied for controlling the switching of the overall circuit. For example, the invention can be applied to an emitter switching topology, but it is possible to use the approach in other cascode topologies. A higher voltage supply is applied to the cascode circuit, whereas a lower voltage supply is used to control the control switch, which can be a MOSFET transistor.

To reduce the collector-emitter saturation voltage from the moment of switching on, a charge carrier injection boost is provided.

The boost current supply circuit comprises a capacitor between the base of the bipolar junction transistor and a terminal of the lower voltage supply. In this way, the charge carrier injection boost is provided by a capacitor connected to the base of the bipolar output transistor. At the time of turn on of the control transistor, a discharge of the capacitor takes place to the base of the bipolar transistor, and this provides the desired charge injection.

The capacitor is larger than normal intrinsic capacitances in the circuit between the base and the same lower voltage supply terminal, for example by at least a factor of 10.

This means that in practice, the size of the capacitor is a function of the power rating of the circuit. For example the capacitor can have a value in nF of between 0.025 and 5 times the power rating in W of the circuit. More preferably, the capacitor can have a value in nF of between 0.25 and 0.5 times the power rating in W of the circuit, in particular for universal mains applications. By way of example, capacitors of 1.5nF, 3.3nF, and 22nF respectively can be used for universal mains applications of 5W, 10W, and 65W. In these examples, the required boosting capacitor value (in nF) is around ⅓ of the rated power for a universal mains application. These capacitors fall in the range 1 nF to 100nF.

A diode is preferably connected in its forward conduction direction between the base of the bipolar junction transistor and a terminal of the lower voltage supply. This is used to provide a discharge path for the base charge of the bipolar transistor after the control switch has switched off.

A current limiting resistor is preferably in parallel with the diode, or another current limiting topology can be used, to limit the current that can be supplied to the base of the bipolar junction transistor during the active state (on-state).

The capacitor can be connected between ground and base of the bipolar junction transistor.. This is for example the case when an NPN bipolar transistor is used and an n-MOS control transistor. However, a PNP and a p-MOS transistor can instead be used.

The bipolar junction transistor can be a single transistor, or it can be part of a Darlington transistor circuit.

The circuit may also comprise a bleeder for start-up purposes.

The invention also provides a method of controlling a switching circuit, which circuit comprises a bipolar junction transistor and a control switch in series with the bipolar junction transistor with a higher voltage supply across the series connection,
wherein the method comprises:
supplying the base of the bipolar junction transistor with current by a lower voltage supply;
turning on the control switch to turn on the bipolar junction transistor and supplying a boost current to the base of the bipolar transistor when the control switch is turned on, wherein the boost current is supplied by a capacitor between the base of the bipolar junction transistor and a terminal of the lower voltage supply..

Examples of the invention will now be described with reference to the accompanying drawings, in which:
Figure 1 shows a known cascode circuit;
Figure 2 shows a first example of switching circuit of the invention;
Figure 3 shows a set of timing diagrams for switching circuit of the invention used in a flyback converter;
Figure 4 shows a flyback converter circuit using the switching circuit of the invention;
Figure 5 shows a modification to the circuit of Figure 4; and
Figure 6 shows how a PNP bipolar transistor can be used instead of the NPN bipolar transistor of Figures 2 and 4.

The invention provides a cascode switching circuit comprising a bipolar junction transistor and a control switch. A boost current supply circuit is coupled to the base of the bipolar junction transistor for supplying a boost current when the control switch is turned on. This reduces the collector-emitter saturation voltage from the moment of switching on.

The emitter switching topology of Figure 1 will first be described.

The power switch consists of a high voltage bipolar NPN transistor (Q1), and a low voltage n-MOS power FET (Q2) or other switching device. An alternative circuit can use a bipolar PNP transistor and a p-MOS power FET. The MOSFET Q2 can also be implemented using other types of switch. The switching device can be a second low voltage bipolar transistor, or JFET, or IGBT, or any other device that can operate as a low voltage switch, instead of the MOSFET shown.

The emitter of the high voltage bipolar transistor Q1 is connected to the drain of the MOSFET Q2, and the source of the MOSFET Q2 is connected to ground (or other reference potential) or to a shunt (resistor) that connects to ground. The collector of the high voltage bipolar transistor Q1 is the switched output terminal. The gate of the power MOSFET is connected to an output signal of a driver logic circuit.

The base of the high voltage bipolar transistor Q1 is connected to a dc voltage source in series with a current limiting device. The value of this voltage source can be chosen arbitrary but in many cases a value between 5V and 15V is selected.

The MOSFET must have a voltage rating of at least equal to the value of the voltage which is applied to the base of the high voltage bipolar transistor. The high voltage bipolar transistor must have a voltage rating of at least the blocking voltage, determined by the system requirements. For a 230V mains operated flyback application 700V blocking voltage (Vcbo - collector to base avalanche breakdown voltage) is often chosen.

In this circuit, the switching signal is applied to the gate of the MOSFET instead of the base of the bipolar transistor, and the complete cascode circuit can be switched by controlling only the gate of the MOSFET Q2.

For example, at the moment the MOSFET Q2 switches to the conductive state, the drain-source voltage is reduced close to zero Volts. The emitter voltage of the high voltage bipolar transistor is also reduced close to zero Volts. As result, a current will flow through the base-emitter of the high voltage bipolar transistor.

When designed properly, the base current is dimensioned to drive the collector-emitter voltage to a sufficiently low level which in turn leads to low on-state conduction losses.

When the MOSFET Q2 is switched off, the drain voltage and will rise. The emitter voltage will rise accordingly to a voltage close to the value of the connected voltage source for the base drive.

At the moment the base-emitter junction is blocked and is unable to carry any current, the excess charge carriers in the bipolar transistor will cause a current from the collector to the base, discharging the collector-base junction space-charge region. This current will flow until the collector-base space-charge region is depleted.

In a flyback application or other topologies where an inductive load is switched, the value of the negative base current is dictated by the actual collector current at switching off.

The time the negative base current is flowing is determined by the amount of excess charge in the collector-base space-charge region that was injected during the on-state of the bipolar transistor. As result, a significant amount of negative base current can flow back to the voltage supply, depending on the injection level.

As a result, a significant part of the base drive energy is recovered and can be reused in the succeeding driving cycle.

Figure 2 shows a first example of a circuit of the invention.

The bipolar transistor and MOSFET are again shown as Q1 and Q2. The gate of the MOSFET Q2 is driven by a control circuit 20, as gate signal G2. The control circuit is connected to the source signal S2, which is for example a rectified mains return signal. The supply voltage Vsupp to the control circuit 20 comes from an auxiliary supply, for example through diode D1.

The output 22 of the circuit is for example provided to an inductor of a flyback circuit.

A capacitor C1 is added between the base of the high voltage bipolar transistor and the return line (ground). This capacitor is used to provide a significant base current injection boost generated during and directly after switching on.

The capacitor C1 also increases the efficiency during switching-off of the high voltage bipolar transistor Q1 because the charge that is stored in the collector-base space charge region that flows out of the base contact is transferred to this capacitor in an essentially lossless fashion.

The capacitor is larger than normal intrinsic capacitances in the circuit between the base and ground (in this example), for example by at least a factor of 10.

This means that in practice, the size of the capacitor is a function of the power rating of the circuit. For example the capacitor can have a value in nF of between 0.025 and 5 times the power rating in W of the circuit. More preferably, the capacitor can have a value in nF of between 0.25 and 0.5 times the power rating in W of the circuit, in particular for universal mains applications.

By way of example, capacitors of 1.5nF, 3.3nF, and 22nF respectively can be used for universal mains applications of 5W, 10W, and 65W. In these examples, the required boosting capacitor value (in nF) is around ⅓ of the rated power for a universal mains application.

A diode D2 is connected between the base of the bipolar transistor and the supply voltage Vsupp and this is used to guarantee a good and efficient path for the negative base current when turning-off the bipolar transistor.

In practical applications a high ohmic bleeder resistor or an internal current source in the control circuit can be implemented for starting up the low voltage supply, as described further below.

The resistor R2 between the voltage supply and the base of the bipolar transistor performs a current limiting function.

When the cascode circuit is changing from on-state to off-state, the negative base current flowing out of the base of Q1 initially charges the capacitor C1. Surplus charge will be transferred to the power supply capacitance (shown as C2) via the diode D2. The switching on and switching off functions will now be described in more detail.

### Switching on

When the cascode circuit is switching-on, MOSFET Q2 is switched-on and is turned to the conductive state. The connection of the drain of MOSFET Q2, and the emitter of Q1, but also the base connection of Q1, is actively pulled down to the ground level.

The capacitor C1 is discharged through the base connection, and as a result this current 'floods' the transistor with charge carriers and turns the high voltage bipolar transistor to the on-state, avoiding losses due to poor saturation, which is commonly noticed immediately after switching-on high voltage bipolar transistors without an additional start-up mechanism.

During the on time, the supply capacitor C2 supplies the base current of the bipolar transistor Q1 through resistor R2.

### Switching off:

When the circuit is switching off, Q2 is switched-off and is turned to the non-conductive state. No current can flow from the emitter of the bipolar transistor Q1 to ground via MOSFET transistor Q2. The collector current instantaneously flows from collector to the base as long as stored charge is present in the collector-base junction. The drain connection of Q2, the emitter connection of Q1, and also the base connection of Q1 rise in voltage due to the collector current, which is forced to flow by the flyback inductor (inductive component).

The capacitor C1 is charged by the negative base current.

As soon as the capacitor voltage reaches Vsupp + VfD2 (VdD2 is the forward voltage drop of the diode D2), the diode D2 starts conducting, until all excess charge carriers in the high voltage transistor are removed.

At the moment all excess charge carriers in the high voltage transistor are removed, the high voltage bipolar transistor Q1 finally turns to the non-conductive mode.

During the part of the off time that the diode D2 is conducting, the supply capacitor C2 is recharged by the collector - base current.

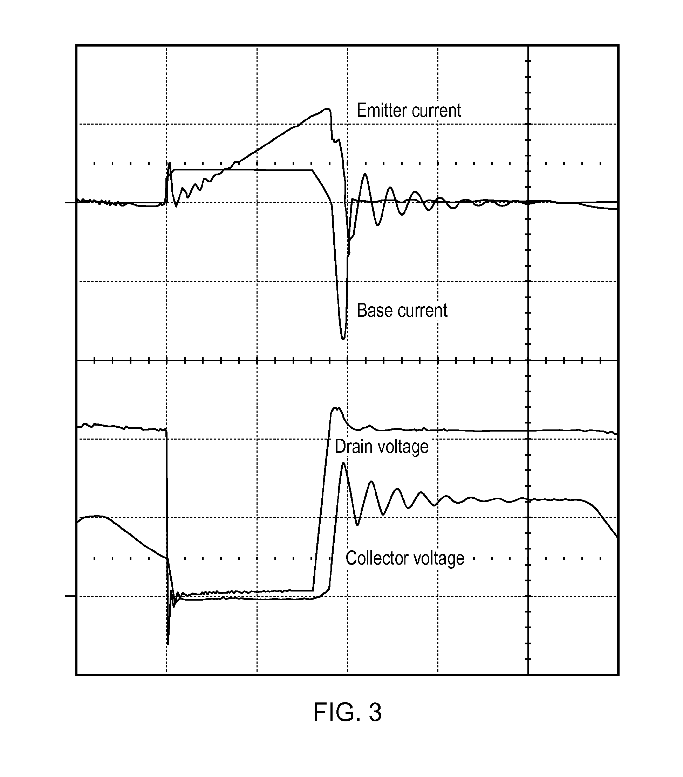

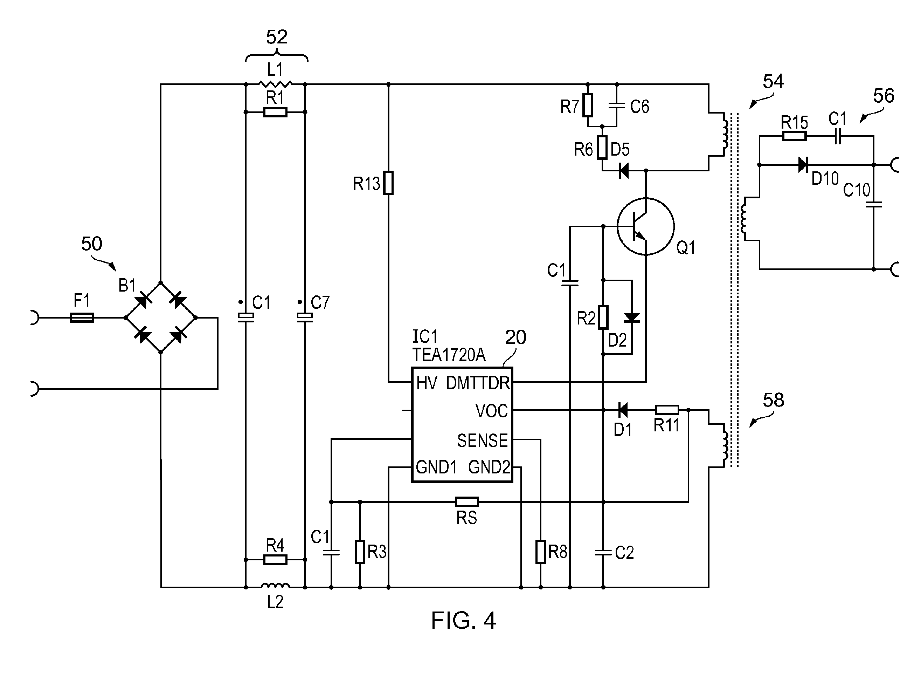

Figure 3 shows the voltage waveforms for a flyback circuit using the switching the circuit of Figure 3. The flyback circuit is shown in Figure 4 and discussed below.

Figure 3 shows the "emitter current", "base current", "drain voltage" and "collector voltage".

A base current peak when the MOSFET is switched on is just visible due to the time scale of this measurement. The collector voltage is low and very close to ground level during almost the complete primary cycle.

The switching on and off is quite fast, as can be seen by the slopes of the collector voltage. As result only limited switching losses / on-state losses will occur.

In practice, the amount of recharge current provided by Q1 can supply a significant part of the driving current required during the on-state.

The drive current can be modulated in such a way that the losses due to poor saturation are avoided (high base current required), and the amount of excess charge is limited (low base current required).

An optimum is reached at the moment the base current of the bipolar transistor is driven in such a way that the collector voltage remains just close to the ground level during the active period. As a result, only limited excess charge is present at the moment of switching off, resulting in relatively fast switching off with low losses. If the base is overdriven, too much injected excess charge will be present in the bipolar transistor resulting in additional switching losses when the charge has to be removed while not or only hardly contributing to lower on-state losses (collector-emitter saturation voltage). There is accordingly an optimum balance between on-state and switching losses.

As result, the bipolar high voltage transistor will be saturated during on-state operation, and the switching time is limited to a minimum. The on-state losses and switching losses can be balanced in such a way that the total losses are minimized.

As example, a flyback application with the emitter switching approach of Figure 2 is shown Figure 4.

The emitter switching circuit consists of the high voltage bipolar transistor Q1 and the low voltage power MOSFET, which in this example is not shown as it can be integrated in the controller IC 20.

The emitter of the high voltage bipolar transistor is connected to the drain of the integrated low voltage power MOSFET.

Figure 4 shows a bridge rectifier 50 for the mains input, and a filter stage 52.

The emitter switching circuit controls the drive signal to the primary winding of transformer 54 which in turn drives the output rectifier circuit 56. A further transformer winding 58 functions as part of a feedback control system for feedback to the controller 20 and as auxiliary low voltage supply for the controller and driver stage.

The basic operation of the flyback circuit is conventional and is not described in further detail.

The emitter switching circuit function is as described above.

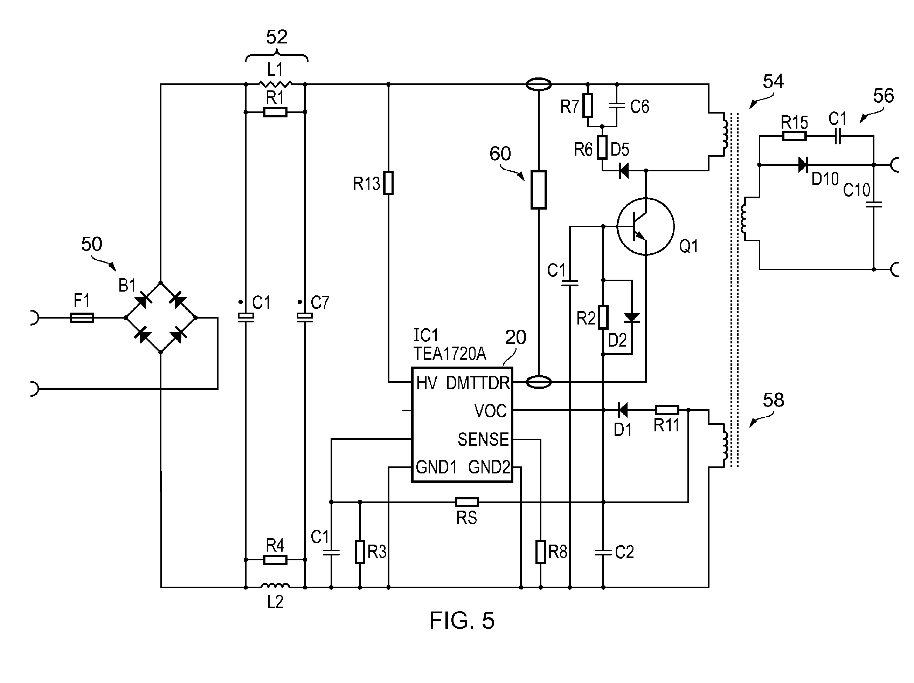

As mentioned above, the low voltage supply for the controller 20 can be fed by a bleeder resistor for the initial powering-up of the Vcc supply. This approach is shown in Figure 5, which is a modification to Figure 4 with the bleeder resistor 60.

As alternative, an integrated start-up circuit can be implemented in the control IC 20. The supply voltage Vcc can initially be charged by an internal high voltage current source, connected to the high voltage supply or the drain pin. As soon as the IC starts operating the auxiliary winding 58 can then take over the low voltage supply current.

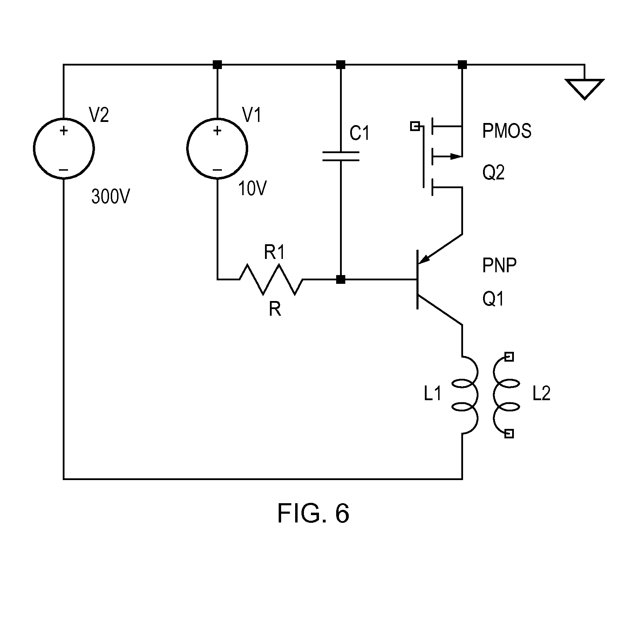

As mentioned above, a PNP and p-MOS version is possible. Figure 6 shows the basic configuration, with a PMOS control switch connected to the high voltage supply line, in series with the PNP bipolar transistor and transformer winding L1. The capacitor C1 in this case is between the high voltage line and the base of the bipolar transistor.

The complete control, driver and output stage can be completely or partly integrated. The design freedom enables an integrated solution with very few external components. In practice all supply capacitors will be placed externally.

The invention can for example be applied to a flyback adapter supply, a flyback LED driver supply (for integrated and non-integrated lamps), or a half bridge LLC (inductor-inductor-capacitor) supply for adapters and integrated supplies (for example for television sets, home cinema sets, or as a LED driver).

The invention can however be applied to any other power supply, where high voltage switches are applied such as greater than 400V across the switching device.

This solution can be implemented in almost all applications, where commonly high voltage MOSFETs (typically 400V) are being employed.

The capacitance value has been explained to be a function of the rated power of the circuit. This applies in particular to a universal mains application (i.e. a voltage range of 100V to 240V). However, a different relationship may apply to other power converter topologies (or other switching application topologies). The capacitor is designed to inject a substantial amount of charge into the base-emitter junction, that aids the bipolar transistor to reach a well saturated state (low collector-emitter voltage) nearly effortlessly. Thus, the size/value of the capacitor is related to the bipolar transistor. Thus, more generally, the capacitor is at least an order of magnitude larger than the parasitic capacitance between the same pair of nodes, so that it does indeed provide a useful additional charge injection function.

The circuits above show a single bipolar transistor. However, the transistor may be replaced by a Darlington transistor pair.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

## Claims

1. A switching circuit, comprising:
a bipolar junction transistor (Q1);
a control switch (Q2) in series with the bipolar junction transistor with a higher voltage supply across the series connection, wherein the base of the bipolar junction transistor (Q1) is supplied with current by a lower voltage supply (Vsupp), and wherein the control switch (Q2) is turned on to turn on the bipolar junction transistor (Q1); and
a boost current supply circuit coupled to the base of the bipolar junction transistor for supplying a boost current to the base of the bipolar transistor (Q1) when the control switch is turned on, wherein the boost current supply circuit comprises a capacitor (C1) between the base of the bipolar junction transistor (Q1) and a terminal of the lower voltage supply.

2. A circuit as claimed in claim 1, wherein the control switch (Q2) comprises a MOSFET transistor.

3. A circuit as claimed in claim 1 or 2, wherein the capacitor (C1) has a value in nF of greater than 0.025 times the power rating in W of the circuit.

4. A circuit as claimed in claim 3, wherein the capacitor (C1) has a value in nF of greater than 0.25 times the power rating in W of the circuit.

5. A circuit as claimed in any preceding claim, wherein the capacitor (C1) has a value in nF of less than 5 times the power rating in W of the circuit.

6. A circuit as claimed in any preceding claim, wherein the capacitor (C1) has a value at least 10 times the equivalent intrinsic parasitic capacitance in the circuit.

7. A circuit as claimed in any preceding claim, comprising a diode (D2) connected in its forward conduction direction between the base of the bipolar junction transistor (Q1) and a terminal (Vsupp) of the lower voltage supply.

8. A circuit as claimed in claim 7, comprising a resistor (R2) in parallel with the diode.

9. A circuit as claimed in any preceding claim, wherein the capacitor (C1) is connected between ground, or reference voltage, and the base of the bipolar junction transistor (Q1).

10. A circuit as claimed in any preceding claim, wherein the bipolar junction transistor is part of a Darlington transistor circuit.

11. A circuit as claimed in any preceding claim, comprising a bleeder resistor (60) for start-up purposes, connected between a high voltage terminal (Vsupp) of the lower voltage supply and .a high voltage terminal of the higher voltage supply.

12. A circuit as claimed in any preceding claim, wherein the emitter of the bipolar junction transistor (Q1) is connected to the drain of control switch, which comprises a MOSFET transistor.

13. A method of controlling a switching circuit, which circuit comprises a bipolar junction transistor (Q1) and a control switch (Q2) in series with the bipolar junction transistor (Q1) with a higher voltage supply across the series connection,
wherein the method comprises:
supplying the base of the bipolar junction transistor (Q1) with current by a lower voltage supply;
turning on the control switch (Q2) to turn on the bipolar junction transistor and supplying a boost current to the base of the bipolar transistor (Q1) when the control switch (Q2) is turned on, wherein the boost current is supplied by a capacitor (C1) between the base of the bipolar junction transistor (Q1) and a terminal of the lower voltage supply..
